# EUROPEAN PATENT SPECIFICATION

(11) **EP 0 392 437 B1**
(45) Date of publication and mention of the grant of the patent: **14.08.1996**
(21) Application number: 90106813.0
(22) Date of filing: 10.04.1990
(51) Int. Cl.: H01L 39/24

(54) **Method for annealing thin film superconductors**
Methode zum Ausheilen eines Dünnschichtsupraleiters
Méthode de recuit de films minces supraconducteurs

(30) Priority: 11.04.1989 JP 91347/89; 11.04.1989 JP 91338/89
(43) Date of publication of application: 17.10.1990
(73) Proprietor: MATSUSHITA ELECTRIC INDUSTRIAL CO., LTD., Kadoma-shi, Osaka-fu, 571 (JP)
(72) Inventor: Setsune, Kentaro, Sakai-shi, Osaka-fu (JP); Wasa, Kiyotaka, Nara-shi, Nara (JP); Ichikawa, You, Moriguchi-shi, Osaka-fu (JP)
(74) Representative: Eisenführ, Speiser & Partner

(56) References cited:
- DE-A- 3 814 277
- APPLIED PHYSICS A, SOLIDS AND SURFACES, vol. 46, August 1988, pages 331-334, Berlin, DE; G. LIBERTS et al.: "Direct laser writing of superconducting patterns into semiconducting Y-Ba-Cu-O"
- JAPANESE JOURNAL OF APPLIED PHYSICS, vol. 26, no. 10, October 1987, pages L1731-L1733, Tokyo, JP; K. MURAKAMI et al.: "Energy beam irradiation of high-Tc superconductors Y1Ba2Cu307-y and H01Ba2Cu307-y"
- EXTENDED ABSTRACTS OF THE 20TH CONFERENCE ON SOLID STATE DEVICES AND MATERIALS, August 1988, pages 435-438, Tokyo, JP; Y. YONEZAWA et al.: "Preparation of high Tc oxide superconducting films by laser annealing"
- JAPANESE JOURNAL OF APPLIED PHYSICS, vol. 28, no. 11, November 1989, pages 2211-2218, Tokyo, JP; S. OTSUBO et al.: "Crystallization induced by laser irradiation in Ba-Y-Cu-O superconducting films prepared by laser ablation"

## Description

The present invention relates to a method for annealing thin film superconductors in accordance with the preamble of claim 1.

There have been known niobium nitride NbN and/or germanium niobium Nb₃Ge being binary compounds of A 15 type as superconducting materials, but their transition temperatures Tc are 24 K at the most. Contrary to this, perovskite trivalent compounds are expected to have a higher transition temperature Tc and, in fact, there has been proposed a high temperature superconductor of Ba-La-Cu-O system (J. G. Bednorz and K. A. Müller, Zeitschrift für Physik, B-Condensed Matter, 64, 189 ∼ 193 (1986)).

Further, some oxide superconductors are discovered to have critical temperatures higher than the temperature of liquid nitrogen (77.3 K) and, therefore, contribute to widen the field of application of the superconductor. Especially, Bi-Sr-Ca-Cu-O superconductor formed by a Bi complex oxide having a layered structure is found to have a transition temperature higher than 100 K (H. Maeda, Y. Tanaka, M. Fukutomi and T. Asano, Japanese Journal of Applied Physics, 27, L209 - 210 (1988)).

Recently, it is reported that Tl-Ba-Ca-Cu-O material makes a transition to a superconducting state at a temperature higher than 120 K and is a complex compound having a layered structure similar to the Bi-superconductor ( Z. Z. Sheng and A. M. Hermann, Letter to Nature, 332, 138 - 139 (1988)).

The mechanism for causing the superconductivity in materials of this type is not made clear in detail, but there is a possibility that the transition temperature is made higher than a room temperature. Accordingly, the trivalent complex compounds of this type are expected to have much more excellent properties than those of the binary compounds mentioned above.

In order to obtain high temperature thin film superconductors having excellent superconducting properties, it is necessary to improve the crystal state of the thin film. According to conventional methods, the substrate on which a thin film is formed is heated up to a high temperature to obtain a regular crystal state. However, the annealing method by heating the substrate has a disadvantage in that crystal grains are grown thereby. These crystal grains make the surface of the thin film uneven and, thereby, it becomes impossible to make a super-fine work of an order of sub-micron on the thin film in order to form various superconducting devices.

In order to obtain even thin films, there was proposed a method in which a thin film is formed by growing a monocrystalline layer on a monocrystalline substrate kept at a low temperature. In this method, SrTiO₃ and MgO is used as a substrate. Further, LaAlO₃ and LaGaO₃ having small dielectric constants are noticed as substrates taking into consideration of future use of superconducting devices in super high frequency field. However, these substrates are very expensive and hard to obtain. Further, film formation conditions for growing the monocrystal homogeneously on the substrate are restricted by the structure of the forming apparatus and it is difficult to obtain superconducting thin films of large areas with a good reproducibility.

Especially, Tl-Ba-Ca-Cu-O or Bi-Sr-Ca-Cu-O material exhibiting the highest critical temperature at the present needs a high temperature process higher than 850 °C which causes the growth of grains. No method for forming thin films with a low temperature process is realized by the present and, therefore, no superconducting thin films having smooth flat surfaces have been obtained.

Y. Jonezawa et al ("Preparation of high Tc oxide superconducting films by laser irradiation", Extended Abstracts of the 20th Conference on Solid State Devices and Materials, August 1988, pages 535-538, Tokyo) disclose the preparation of Ba-Y-Cu-O films by using a pulsed laser evaporation and a pulsed laser irradiation as annealing techniques. It is reported by these authors that supercoducting films with Tc(end) = 67 K were obtained by a CO₂ pulsed laser annealing of as-deposited amorphous films on (100) SrTiO₃ followed by low-temperature annealing.

It is the object of the present invention to provide a new method for obtaining thin film superconductors with excellent properties.

This object is attained by a method as defined in claim 1. Suitable and preferred embodiments are described in the subclaims.

In a preferred embodiment of the present invention a cover film on the oxide thin film superconductor is formed. In this embodiment, the oxide thin film superconductor is heated through the cover film and the evenness of the oxide thin film superconductor is maintained or guaranteed by the cover film.

This method makes formation of devices utilizing thin film superconductors easier.

It is to be noted that the thin film oxide superconductor having a layered structure needs oxygen upon crystal growth and, accordingly, a good crystal structure upon heating may be obtained by using a container into which a gas including oxygen and/or nitrogen suboxide or nitrogen sulfide is introduced.

Available heating means are linear irradiation using a scanning laser beam or electron beam, linear heating using focused infrared rays, high frequency heating or strip heaters. In this case, the linear heating means and the thin film oxide superconductor are moved relative to each other.

The material for the cover film is desirably selected among materials which are transparent to the infrared light and have a melting point higher than 1000 °C.

As the materials which satisfy the above conditions, oxides, fluorides and perovskite oxides are available.

The present invention utilizes such a property that the crystal structure of heating and melting part is arranged to that of the peripheral solid state portion is kept as it is during the cooling process. Due to this effect, impurities are removed and the crystallization is promoted. Accordingly, it becomes possible to obtain single crystal thin films of large areas by optimizing the heating conditions.

According to one aspect of the present invention, there is formed a cover film on the thin film superconductor. This cover film prevents generation of roughness reflecting grain structure of the surface thereof which is generated in a usual thermal treatment and, thereby, guarantees to obtain thin films having flat surfaces.

In this case, the heating temperature is set not to melt the cover film and the crystal growth is promoted during cooling of the heated and melted portion thereof. This enables the monocrystal growth over a wide area.

This method corresponds to the zone melting recrystallization method known as a recrystallization method. In the present invention, this method is applied to the oxide thin film having a layered crystal structure and, thereby, makes it possible to obtain layered oxide thin films having flat or even surfaces and excellent crystal structures.

In another aspect of the present invention, the oxide thin film superconductor is heated partially in a container into which a gas including nitrogen suboxide or nitrogen sulfide. This gas contributes to promote oxidization of metal elements compositting the oxide thin film superconductor and, thereby, the crystal structure is improved. Further, by moving the portion to be heated at a predetermined speed, the crystal growth in a transversal direction is promoted and, thereby, the increase of the critical current density and the flatness of the surface of the thin film are obtained since the grain size is expected to increase when compared with the conventional method.

These and other objects and features of the present invention will become clear from the following description taken in conjunction with the preferred embodiment thereof with reference to the accompanying drawings, in which:
Fig. 1 is a schematic view showing a crystal structure of a layered oxide thin film superconductor including Cu-O layers,
Fig. 2 is a schematic perspective view of an apparatus for producing thin films which is comprised of plural targets and a shutter,
Fig. 3 is a schematic sectional view of the thin film superconductor according to the preferred embodiment of the present invention,
Fig. 4 is an explanatory view for showing the annealing method according to the preferred embodiment of the present invention,
Fig. 5(a) is a schematic sectional view for showing a crystal structure of the oxide superconductive thin film before the annealing treatment, and
Fig. 5(b) is a schematic sectional view showing a crystal structure of the oxide superconductive thin film after the annealing treatment.

Y-Ba-Cu-O, Bi-Sr-Ca-Cu-O and Tl-Ba-Ca-Cu-O oxides having a layered structure are discovered as high Tc superconductors. These oxides are characterized in that they are crystals including Cu-O layers.

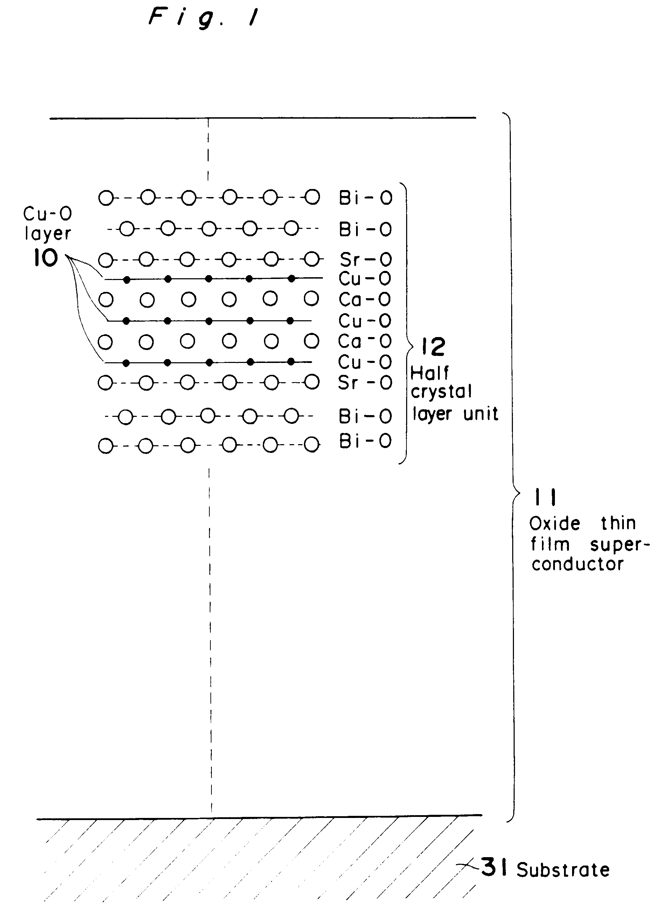

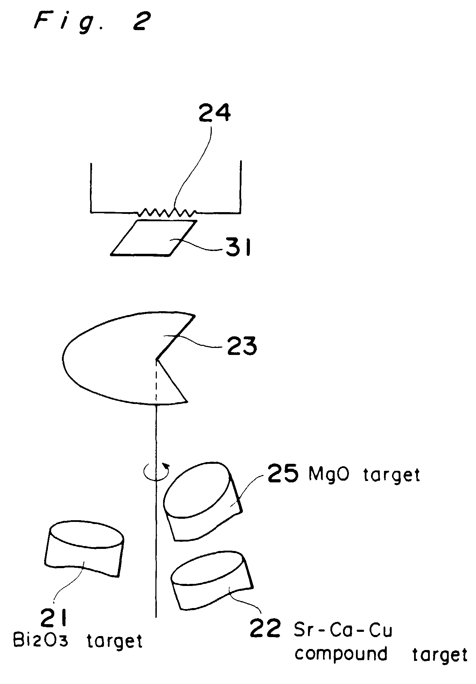

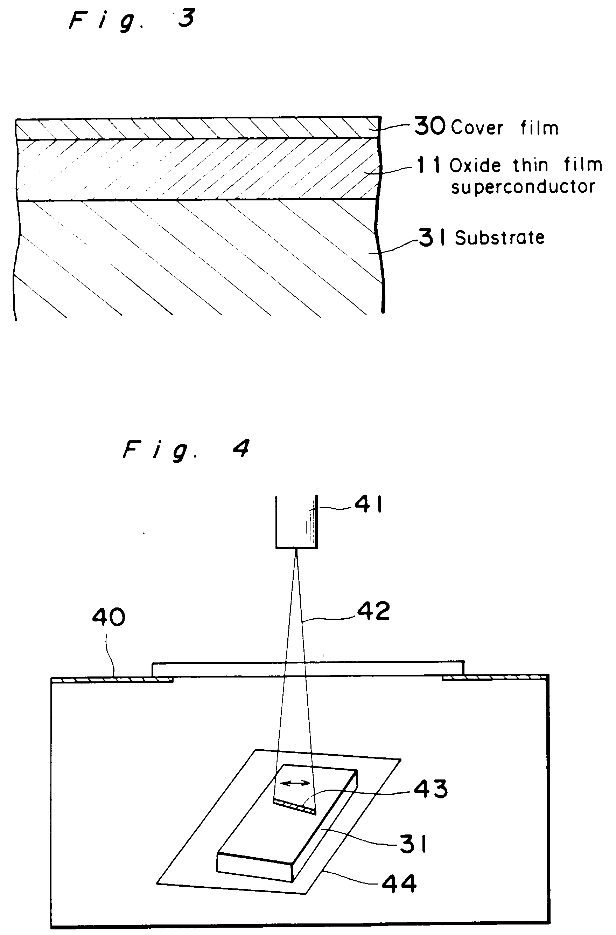

Fig. 1 shows a schematic layered crystal structure of the thin film oxide superconductor 11 of Bi₂Sr₂Ca₂Cu₃Oy. The Cu-O layer is considered to contribute to the superconductivity to some extent but the role thereof is not fully studied for the present.

In the preferred embodiment, the Bi-Sr-Ca-Cu-O system is explained as an example.

Individual elements and/or compounds as evaporation sources which composite the superconductor are deposited alternatingly on a substrate kept at a temperature lower than 800 °C in a gas containing oxygen to stack them periodically on the substrate.

When the deposition rates of the respective evaporation sources are adjusted properly in the deposition process, it is discovered that a phase having a critical temperature Tc equal to or higher than 100 K is generated corresponding to the period of stack of layers. It is observed that an excellent crystal structure of a phase having a high Tc ( ≥ 100 K) is obtained when the temperature of the substrate is kept at a range from 500 to 800 °C. Thus, thin film oxide superconductors are obtained.

There are considered some methods for stacking individual elements and/or compounds constituting the superconductor periodically. In general, it can be attained to stack layers periodically by controlling shutters arranged in front of respective evaporation sources in MBE apparatus or EB deposition apparatus of multi-sources or switching the kind of gas in the gas phase growing method. The sputtering method using the plasma discharge or the laser beam also enables to form an excellent stack of layers. In this case, a high pressure of oxygen during the sputtering and the sputter discharge contribute advantageously to form the phase having a high Tc ( ≥ 100 K) in the Bi complex oxide having a layered structure.

As shown in Fig. 3, a cover film 30 is formed on the thin film oxide superconductor 11 having been formed on the substrate 31. The sputtering method or EB deposition method being suitable for forming transparent insulating films is advantageously used for forming the cover film 30.

Upon forming the thin film, a Si-Ca-Cu compound target 22 and a Bi₂O₃ target 21 are set in a vacuum apparatus, as shown in Fig. 2, and, at first, Ar and oxygen gasses are introduced therein to generate discharges and sputtering conditions are set. The formation of the thin film on the surface of the substrate 31 maintained at 700 °C by a heater 24 is started by depositing Bi IIa family and Cu thereon by sputtering the Bi₂O₃ target 21 and the Sr-Ca-Cu compound target 22. In this case, the Bi complex oxide thin film superconductor 11 having a layered structure is formed by setting the sputtering conditions suitably and controlling the shutter 23 so as to coincide the composition of the thin film with the stoichiometry ratio of Bi oxide superconductor. In other words, the Bi oxide superconductor is obtained by adjusting the rotation time of the shutter 23 and applying electric powers to respective targets.

After forming the oxide thin film superconductor 11 of a thickness of 500 Å according to the method mentioned above, the introduction of the oxygen gas is stopped and, then, a high frequency electric power is applied to a MgO target 25 set in the vacuum apparatus to sputter the target 25 in Ar gas atmosphere. Due to this sputtering process, the cover film 30 of the thickness of about 3000 Å is formed on the surface of the oxide thin film superconductor 11 having been formed. The cover film 30 is easily formed using the sputtering method. However, all other methods which enable to form homogeneous and uniform films are available. MgO, magnesia spinel, ZrO₂, YSZ, SrTiO₃ and the like are suitable for the cover film 30. Further, CaF₂, BaF₂, SrF₂, BiF₃, CaO, SrO, BaO, BiO₃, Cu₂O and perovskite oxides such as LaAlO₃, LaGaO₃, Bi₄Ti₃O₁₂, Bi₂Ti₄O₁₁ and the like are available when taken the matching with the material forming the superconductor into consideration.

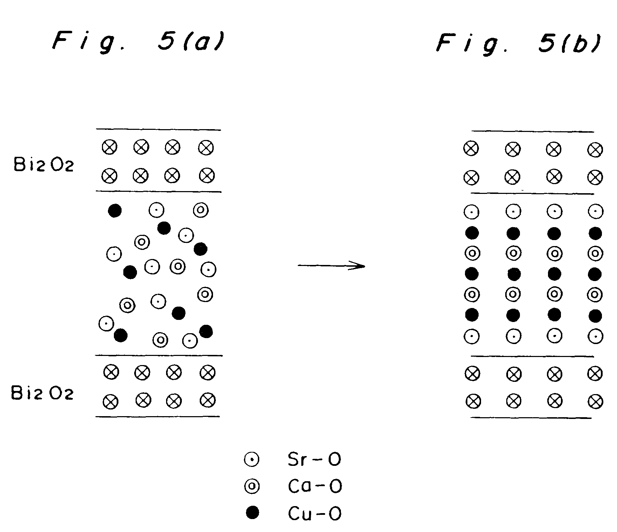

As shown in Fig. 4, the substrate 31 with only the complex oxide thin film superconductor 11 or with the superconductor 11 and the cover film is set in an evacuated container 40 into which at least oxygen, nitrogen suboxide or nitrogen sulfide is introduced and is irradiated by scanning the surface thereof with a laser beam 42 emitted from a CO₂ laser 41 arranged outside the container. The substrate 31 is moved at a speed of 1 cm/min. in a direction perpendicular to the scan direction of the laser beam 42. In place of the laser, a scanning electron beam or infrared rays emitted from an infrared lamp and focused linearly on the substrate are available for annealing. Further, high frequency heating or a strip heater is usable therefore. In the case of the heating by the electron beam, the substrate is set in the vacuum apparatus but the gas mentioned above is not to be introduced. The heating portion 43 of the complex oxide thin film superconductor 11 heated by the heating means is melted and, when the heating portion 43 is moved, the melted portion is cooled and is monocrystallized. Even if the heating portion is not melted completely, mismatches in the crystal structure caused during the formation of the layered complex oxide thin film superconductor, crystal defects which affect to the superconductive properties, lattice mismatches in the crystal grain boundary and impurities can be removed by heating individual heating portions and, therefore, the superconducting properties of the oxide thin film superconductor are improved.

It is desirable to set the substrate 31 on a plane heater 44 in order to heat it with a plane auxiliarily. This enables to reduce the electric power to be supplied to the heating source for the linear heating and makes the control thereof easier. Of course, the temperature of the plane heater 44 is set lower than the melting point of the layered complex oxide thin film superconductor. Thus, it becomes possible to improve the crystal structure of the thin film by annealing it according to the present invention.

As the result of an analysis of the crystal structure of the thin film using the X-ray diffraction method, it is confirmed that the crystal phase of the Bi layered complex oxide can be controlled by adjusting the moving speed and the heating energy of the linear heating portion, and/or the temperature of the plane heater.

The crystal structure is improved by the heating treatment mentioned above and, in the case that the surface of the oxide superconductor is covered by the cover film, the flatness of the surface thereof is maintained by the cover film.

It becomes necessary to remove the cover film in order to form devices using the oxide thin film superconductor obtained. In order for that, the ion milling method can be advantageously used.

According to this method, Ar gas is introduced into the vacuum container and ionized. Ar ions are accelerated to collide to the cover film and, thereby, it is sputtered off. The inventors of the present invention confirmed that the flat surface is maintained by this method.

Fig. 5(a) shows a schematic crystal structure of Bi-Si-Ca-Cu-O oxide thin film superconductor formed by the sputtering and Fig. 5(b) shows a schematic crystal structure of the same after annealing by irradiating a laser beam according to the present invention.

As shown in Fig. 5(a), Sr-O, Ca-O and Cu-O are mixed with each other in the oxide thin film superconductor formed by the sputtering. By the annealing treatment, they are rearranged to form a regular layered structure, as shown in Fig. 5(b).

Conventionally, it is known that the thin film superconductor having such a regular layered structure as shown in Fig. 5(b) can be obtained by annealing the same using oxygen gas at a temperature in a range 850 to 900 °C. As far as the critical temperature is concerned, there is no difference between the conventional annealing method and the present invention. But, the inventors of the present invention discovered that the density of the critical current is increased according to the present invention when compared with the conventional annealing method.

It is to be noted that the same result is obtained by replacing oxygen gas with N₂O completely. The inventors of the present invention discovered that an excellent layered crystal structure of Bi-Sr-Ca-Cu-O oxide thin film superconductor could be obtained at an annealing temperature in a range 600 to 800 °C lower than that needed in the annealing without N₂O when N₂O was added. Though the mechanism of this effect is not understood fully, it is considered that N₂O is thermally dissociated at a relatively low temperature of about 400 °C and excited oxide radicals generated upon the thermal dissociation promote crystallization and oxidization of metal elements to grow crystal grains enoughly.

Further, the same results as the case of N₂O gas was obtained by subjecting the annealing treatment by adding nitrogen sulfide (N₂S) to oxygen gas. It was confirmed by the inventors of the present invention that the Bi-Sr-Ca-Cu-O oxide superconductor thin film having an excellent layered structure could be obtained when the pressure ratio of N₂S to O₂ was kept within a range 0.05 to 1.00.

The inventors of the present invention also confirmed that the present invention was especially effective for oxide superconductors having layered structures including Cu-O layers since they had layered structures and crystals were apt to grow in a transversal direction, namely in a direction parallel to the base plane of the substrate.

According to the present invention, thin films on a substrate of large size can be produced with a good reproducibility in high Tc superconductive materials represented by the Bi-Sr-Ca-Cu-O oxide superconductor. Therefore, it becomes possible to make super fine works of a sub-micron order. This makes the formation of various superconductive devices easier and, accordingly, the present invention is valuable for the industrial use.

## Claims

1. A method for annealing thin film superconductors comprising a substrate and an oxide thin film formed on the substrate, the method comprising irradiating a zone on the oxide thin film with a high energy beam to heat said zone, wherein the high energy beam is scanned and the oxide thin film is moved at a predetermined speed relative to the scan direction to scan a predetermined area of the oxide thin film,
**characterized in that**
said oxide thin film has the structure of multiple crystal layers formed on and in parallel to the substrate and including at least two different layers deposited alternatingly, one of which including a Cu-O layer.

2. The method of claim 1, characterized by forming a cover film on said thin film superconductor through which it is irradiated.

3. The method of claim 1 or 2, characterized in that irradiation of said thin film superconductor is carried out in a container into which a gas is introduced comprising oxygen, nitrogen suboxide and/or nitrogen sulfide.

4. The method of one of the preceeding claims, characterized in that irradiation of said thin film superconductor is carried out by linear irradiation using a scanned laser beam or electron beam, linear heating using focused infrared rays, high frequency heating, or by means of a strip heater.

5. The method of one of the preceeding claims, characterized in that said cover film is made of at least one material selected from perovskite oxides, magnesium oxide, magnesia spinel, calcium fluoride, barium fluoride, strontium fluoride, bismut fluoride, calcium oxide, strontium oxide, barium oxide, bismut oxide and copper oxide.

6. The method of claim 4, characterized in that irradiation of said thin film superconductor is carried out while heating the substrate by a plane heating device.

## Patentansprüche

1. Verfahren zum Tempern von Dünnschicht-Supraleitern, die ein Substrat und eine auf dem Substrat gebildete Oxid-Dünnschicht aufweisen, wobei man bei dem Verfahren eine Zone auf der Oxid-Dünnschicht zur Erwärmung der Zone mit einem Hochenergiestrahl bestrahlt, wobei der Hochenergiestrahl gescannt und die Oxid-Dünnschicht mit vorbestimmter Geschwindigkeit relativ zur Scannrichtung bewegt wird, so daß ein vorbestimmter Bereich der Oxid-Dünnschicht dem Scannen unterworfen wird,
**dadurch gekennzeichnet**, daß
die Oxid-Dünnschicht die Struktur mehrerer Kristallschichten hat, die auf und parallel zum Substrat ausgebildet sind und mindestens zwei unterschiedliche Schichten umfaßt, die alternierend abgeschieden sind, wobei eine davon eine Cu-O-Schicht umfaßt.

2. Verfahren nach Anspruch 1, dadurch gekennzeichnet, daß man auf dem Dünnschicht-Supraleiter eine Abdeckschicht bildet, durch die er bestrahlt wird.

3. Verfahren nach Anspruch 1 oder 2, dadurch gekennzeichnet, daß man das Bestrahlen des Dünnschicht-Supraleiters in einem Behälter ausführt, in den man ein Gas einleitet, welches Sauerstoff, Distickstoffmonoxid und/oder Distickstoffmonosulfid enthält.

4. Verfahren nach einem der vorhergehenden Ansprüche, dadurch gekennzeichnet, daß man die Bestrahlung des Dünnschicht-Supraleiters durchführt durch lineare Bestrahlung unter Verwendung eines gescannten Laserstrahls oder Elektronenstrahls, durch lineares Erwärmen unter Verwendung von fokusierter IR-Strahlung, durch Hochfrequenzheizung oder mit Hilfe eines Heizbandes.

5. Verfahren nach einem der vorhergehenden Ansprüche, dadurch gekennzeichnet, daß die Abdeckschicht hergestellt ist aus mindestens einem Material, ausgewählt aus Perovskitoxiden, Magnesiumoxid, Magnesiaspinel, Calciumfluorid, Bariumfluorid, Strontiumfluorid, Wismutfluorid, Calciumoxid, Strontiumoxid, Bariumoxid, Wismutoxid und Kupferoxid.

6. Verfahren nach Anspruch 4, dadurch gekennzeichnet, daß man das Bestrahlen des Dünnschicht-Supraleiters durchführt, während das Substrat mit einer ebenen Heizeinrichtung erwärmt wird.

## Revendications

1. Procédé pour recuire des supraconducteurs à film mince comprenant un substrat et un fin film d'oxyde formé sur le substrat, le procédé comprenant l'irradiation d'une zone sur le fin film d'oxyde avec un faisceau d'énergie élevée pour chauffer ladite zone, où le faisceau d'énergie élevée est soumis à un balayage et le fin film d'oxyde est enlevé à une vitesse donnée par rapport au sens du balayage de manière à balayer une zone prédéterminée du fin film d'oxyde,
**caractérisé** en ce que :
ledit fin film d'oxyde a la structure de multiples couches cristallines formées sur et en parallèle avec le substrat et comportant au moins deux couches différentes disposées en alternance, dont l'une comporte une couche de Cu-O.

2. Procédé selon la revendication 1, caractérisé par la formation d'un film de couverture sur ledit supraconducteur à film mince par l'intermédiaire duquel il est irradié.

3. Procédé selon la revendication 1 ou 2, caractérisé en ce que l'irradiation dudit supraconducteur à film mince est effectuée dans un conteneur dans lequel un gaz est introduit qui comprend de l'oxygène, du sous-oxyde d'azote et/ou du sulfure d'azote.

4. Procédé selon l'une des revendications précédentes, caractérisé en ce que l'irradiation dudit supraconducteur à film mince est effectuée par une irradiation linéaire utilisant un balayage d'un faisceau laser ou d'un faisceau électronique, un chauffage linéaire employant des rayons infrarouges focalisés, un chauffage à haute fréquence, ou au moyen d'un élément chauffant en bande.

5. Procédé selon l'une des revendications précédentes, caractérisé en ce que ledit film de couverture est constitué d'au moins un matériau choisi parmi les oxydes de pérovskite, l'oxyde de magnésium, le spinelle de magnésie, le fluorure de calcium, le fluorure de baryum, le fluorure de strontium, le fluorure de bismuth, l'oxyde de calcium, l'oxyde de strontium, l'oxyde de baryum, l'oxyde de bismuth et l'oxyde de cuivre.

6. Procédé selon la revendication 4, caractérisé en ce que l'irradiation dudit supraconducteur à film mince est effectuée tout en chauffant le substrat avec un dispositif de chauffage plan
